(19) Europäisches Patentamt / European Patent Office / Office européen des brevets

(11) **EP 2 495 773 A1**

(12) **EUROPEAN PATENT APPLICATION**
published in accordance with Art. 153(4) EPC

(43) Date of publication:
**05.09.2012 Bulletin 2012/36**

(51) Int Cl.:
***H01L 33/00*** (2010.01)

(21) Application number: **11826153.6**

(22) Date of filing: **05.08.2011**

(86) International application number:
**PCT/CN2011/078058**

(87) International publication number:
**WO 2012/058961 (10.05.2012 Gazette 2012/19)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **03.11.2010 CN 201010530522**

(71) Applicant: **Xi'an Aepitek Opto-Electronic Technology Co., Ltd.
Shaanxi 710100 (CN)**

(72) Inventors:
• **NIOU, Chorng
Shaanxi 710100 (CN)**
• **CHANG, Andrew
Shaanxi 710100 (CN)**

(74) Representative: **Tischner, Oliver
Lavoix Munich
Bayerstrasse 85a
80335 Munich (DE)**

(54) **LIGHT-EMITTING DIODE AND METHOD FOR MANUFACTURING SAME**

(57) An LED and its fabrication method are disclosed. The LED includes: a sapphire substrate (200); an epitaxial layer (220), an active layer (230) and a capping layer (240) arranged on the sapphire substrate (200) in sequence; wherein a plurality of bifocal microlens structures (201) are formed on the surface of the sapphire substrate (200) close to the epitaxial layer (220). The bifocal microlens structures (201) can increase the light reflected by the sapphire substrate (200), raising the external quantum efficiency of the LED, thus increasing the light utilization rate of the LED. Furthermore, the bifocal microlens structures (201) can improve the lattice matching between the sapphire substrate (200) and other films, reducing the crystal defects in the film formed on the sapphire substrate (200) and increasing the internal quantum efficiency of the LED.

Fig. 2

EP 2 495 773 A1

## Description

### TECHNICAL FIELD

The present invention relates to the light emitting field, and more particularly, to a light emitting diode and its fabrication method.

### BACKGROUND ART

Light Emitting Diode (LED), having the advantages of long service life, low energy consumption and others, is widely used in various fields. In particular, with the greatly improved lighting performance, LED is often used as a light emitting device in lighting field. Wherein, the group III-V compound semiconductors such as gallium nitride (GaN), has tremendous application potential in high-brightness blue LED, blue laser and other photoelectric devices due to its wide band gap, high light emitting efficiency, high electronic saturation drift velocity, stable chemical property and other characteristics, which has aroused wide attention.

However, those semiconductor LEDs in the prior art have the problem of low light emitting efficiency. For a conventional LED without packaging, the light extraction efficiency is generally several percent, because a large amount of energy gathers in the device and fails to give out, thus causing energy waste and also affecting the service life of the device. Therefore, to improve the light extraction efficiency of a semiconductor LED is of vital importance.

Based on the abovementioned application demands, many methods for increasing the light extraction efficiency of an LED are applied to the devices, for instance: surface roughening and metal reflector structures.

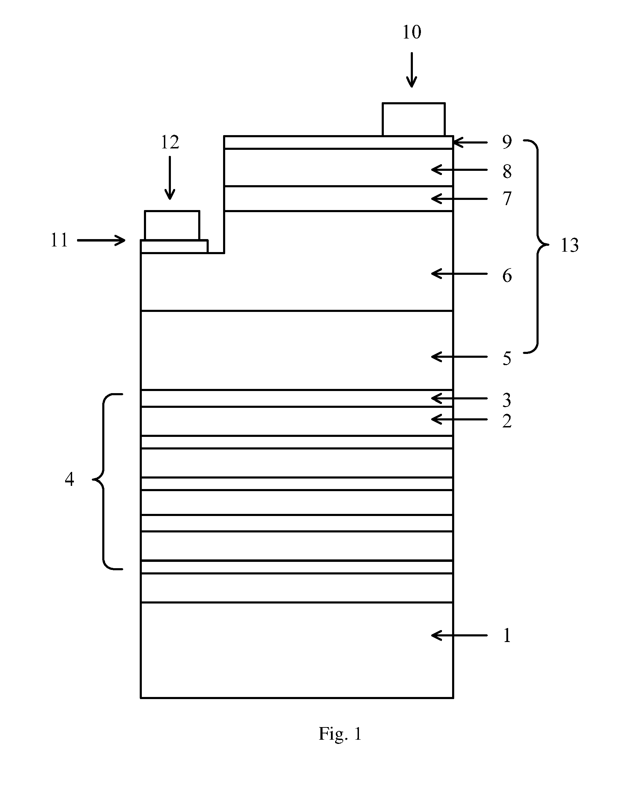

CN 1858918A discloses a GaN-based LED with an omnidirectional reflector structure and its fabrication method. According to FIG. 1, the LED comprises: a substrate 1, an omnidirectional reflector 4 grown on the substrate 1, and a GaN LED chip 13 fabricated on the omnidirectional reflector 4. The GaN LED chip 13 includes: a sapphire substrate 5, an N type GaN layer 6, an active region quantum well layer 7, a P type GaN layer 8, a P type electrode 9, a P type soldering pad 10, an N type electrode 11, and an N type soldering pad 12; wherein the omnidirectional reflector 4 grown on the substrate 1 is stacked by high refractive index layers 3 and low refractive index layers 2, a high refractive index layer 3 is in contact with the sapphire substrate 5, a low refractive index layer 2 is in contact with the substrate 1, the refractive index of the high refractive index layers $n_H$ > the refractive index of the low refractive index layers $n_L$ > the refractive index of the sapphire material n, and satisfies the formula of

$$\sin^{-1} \frac{n}{n_H} < \tan^{-1} \frac{n_L}{n_H},$$

wherein n, $n_H$ and $n_L$ represent refractive index. This patent forms an omnidirectional reflector structure on the bottom surface of the LED chip to reflect the light emitted by GaN material at a high refractive index upwards within the omnidirectional range so as to improve the light extraction efficiency of the LED. However, the fabrication process of the LED requires the forming of a film structure stacked by multiple high refractive index layers and low refractive index layers on the substrate, which is a complicated technique and is unfavourable to put into application.

Therefore, how to provide a simple manufacturing process to increase the light reflected by the sapphire substrate and raise the external quantum efficiency of the LED has become a problem to be solved by those skilled in the art.

### SUMMARY OF THE INVENTION

One objective of the present invention is to provide a light emitting diode to solve the problem of low light extraction efficiency of conventional light emitting diodes.

Another objective of the present invention is to provide a fabrication method of light emitting diode with simple process to improve the light extraction efficiency of light emitting diodes.

To solve the above-mentioned technical problems, the present invention provides a light emitting diode, the light emitting diode comprises: a sapphire substrate; an epitaxial layer, an active layer and a capping layer arranged on the sapphire substrate in sequence; wherein, a plurality of bifocal microlens structures are formed on the surface of the sapphire substrate close to the epitaxial layer.

In the above light emitting diode, a buffer layer is further comprised between the sapphire substrate and the epitaxial layer.

In the above light emitting diode, a transparent conductive layer is further comprised on the capping layer.

In the above light emitting diode, a first electrode, a second electrode, and an opening with its depth extending to the epitaxial layer are further comprised, wherein, the first electrode is on the transparent conductive layer to connect the transparent conductive layer to the positive terminal of a power; the second electrode is in the opening to connect the epitaxial layer to the negative terminal of the power.

In the above light emitting diode, the material of the epitaxial layer is N-doped gallium nitride; the active layer comprises a multiple-quantum-well active layer, the material of the multiple-quantum-well active layer is indium-gallium nitride; the material of the capping layer is P-doped gallium nitride.

Correspondingly, the present invention further provides a fabrication method of light emitting diode, the fabrication method comprising: providing a sapphire substrate; etching the sapphire substrate to form a plurality of bifocal microlens structures; and forming an epitaxial layer, an active layer and a capping layer on the sapphire substrate in sequence.

In the above fabrication method of light emitting diode, the step of forming a plurality of bifocal microlens structures comprises: forming a plurality of cylindrical photoresist blocks on the sapphire substrate; baking the cylindrical photoresist blocks to turn the cylindrical photoresist blocks into spherical-crown photoresists; performing a first inductive coupled plasma etch process by using the spherical-crown photoresists as mask; performing a second inductive coupled plasma etch process, wherein the coil power of the second inductive coupled plasma etch process is lower than the coil power of the first inductive coupled plasma etch process.

In the above fabrication method of light emitting diode, in the first inductive coupled plasma etch process, the etching gas is a mixture of boron trichloride, helium gas and argon gas, the cavity pressure is 50mTorr~2Torr, the plate power is 200W~300W, the coil power is 300W~500W.

In the above fabrication method of light emitting diode, in the second inductive coupled plasma etch process, the etching gas is a mixture of boron trichloride, helium gas and argon gas, the cavity pressure is 50mTorr~2Torr, the plate power is 200W~300W, the coil power is 270W-450W.

In the above fabrication method of light emitting diode, the cylindrical photoresist blocks are baked under a temperature of 120~250 to turn the cylindrical photoresist blocks into spherical-crown photoresists.

In the above fabrication method of light emitting diode, the material of the epitaxial layer is N-doped gallium nitride; the active layer comprises a multiple -quantum-well active layer, the material of the multiple-quantum-well active layer is indium-gallium nitride; the material of the capping layer is P-doped gallium nitride.

In the above fabrication method of light emitting diode, before the formation of the epitaxial layer, further comprises: forming a buffer layer on the sapphire substrate.

In the above fabrication method of light emitting diode, after the formation of the capping layer, further comprises: forming a transparent conductive layer on the capping layer.

In the above fabrication method of light emitting diode, after the formation of the transparent conductive layer, further comprises: forming a first electrode on the transparent conductive layer; forming an opening with its depth extending to the epitaxial layer; forming a second electrode in the opening.

With the adoption of the technical solution above, compared with the prior art, the present invention has the following advantages:

The sapphire substrate of the LED has a plurality of bifocal microlens structures on the surface close to the epitaxial layer. The bifocal microlens structures can increase the light reflected, raising the external quantum efficiency of the LED, thus increasing the light utilization rate of the LED. Furthermore, the formation of a plurality of bifocal microlens structures can improve the lattice matching between the sapphire substrate and other films, reducing the crystal defects in the film formed on the sapphire substrate, increasing the internal quantum efficiency of the LED, and making sure that the device is unlikely to break. In addition, the fabrication method of light emitting diode of the present invention has simple manufacturing process and is easy to implement.

**BRIEF DESCRIPTION OF THE DRAWINGS**

FIG. 1 is a schematic view of an LED in the prior art;
FIG. 2 is a schematic view of an LED according to one embodiment of the present invention;
FIG. 3 is a flow chart of a fabrication method of LED according to one embodiment of the present invention;
FIG. 4A~4E are sectional views of a fabrication method of LED according to one embodiment of the present invention;
FIG. 5 is a top view of cylindrical photoresist blocks according to one embodiment of the present invention.

**DETAILED DESCRIPTION OF THE INVENTION**

To make the abovementioned purposes, features and merits of the present invention clearer and easier to understand, the present invention is further detailed by embodiments in combination with the drawings.

The core spirit of the present invention is to provide an LED and its fabrication method. The LED comprises: a sapphire substrate; an epitaxial layer, an active layer and a capping layer arranged on the sapphire substrate in sequence; wherein, a plurality of bifocal microlens structures are formed on the surface of the sapphire substrate close to the epitaxial layer. The bifocal microlens structures can increase the light reflected, raising the external quantum efficiency of the LED, thus increasing the light utilization rate of the LED. Furthermore, the formation of a plurality of bifocal microlens structures can improve the lattice matching between the sapphire substrate and other films, reducing the crystal defects in the film formed on the sapphire substrate, increasing the internal quantum efficiency of the LED, and making sure that the device is unlikely to break. In addition, the fabrication method of light emitting diode of the present invention has fewer manufacturing steps and has a lower manufacturing cost.

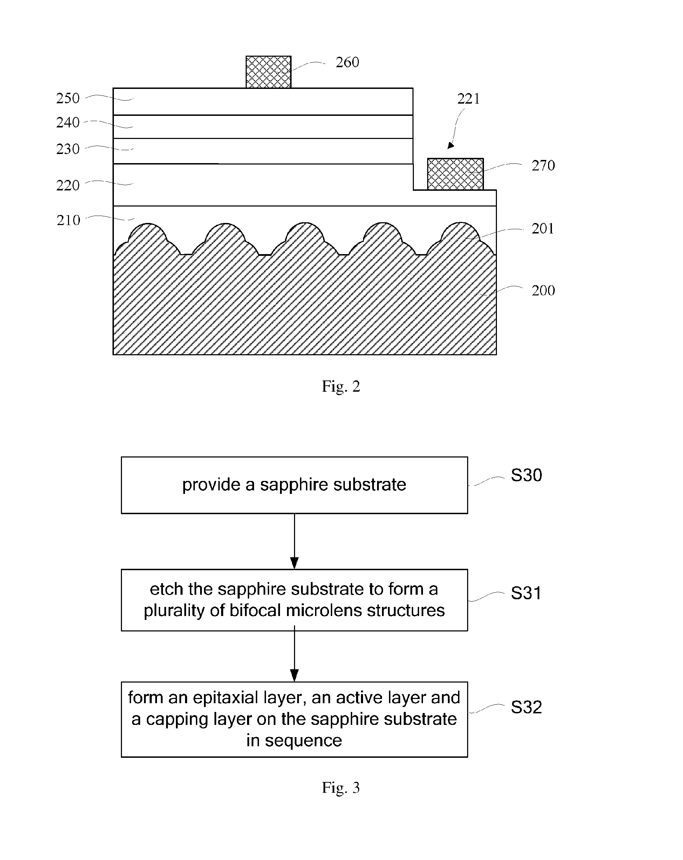

Please refer to FIG. 2, which shows a schematic view of a light emitting diode (LED) according to one embodiment of the present invention. The LED is a light emitting diode with sapphire as the substrate. The LED is a gallium nitride based blue LED. As shown in FIG. 2, the LED comprises: a sapphire substrate 200 as well as an epitaxial layer 220, an active layer 230 and a capping layer 240. The sapphire substrate 200 has a plurality of bifocal microlens structures 201 on the surface close to the epitaxial layer 220.

In this embodiment, the bifocal microlens structure 201 is composed of upper and lower two parts. The lower part is a structure of circular truncated cone with a larger diameter; the upper part is a structure of circular truncated cone with a smaller diameter. The bifocal microlens structures 201 can modify the critical angle of total reflection and increase the light reflected by the sapphire substrate 200, raising the external quantum efficiency of the LED, thus increasing the light utilization rate of the LED. Furthermore, the bifocal microlens structures 201 can improve the lattice matching between the sapphire substrate 200 and other film (the buffer layer 210 in this embodiment), reducing the crystal defects in the buffer layer 210 formed on the sapphire substrate, increasing the internal quantum efficiency of the LED, and making sure that the device is unlikely to break.

The LED further comprises a buffer layer 210 which is between the sapphire substrate 200 and the epitaxial layer 220. The buffer layer 210 can further solve the problem of lattice constant mismatch between the sapphire substrate 200 and gallium nitride material. The buffer layer 210 generally adopts a gallium nitride film grown under low temperature.

The epitaxial layer 220, the active layer 230 and the capping layer 240 are arranged on the sapphire substrate 200 in sequence. The epitaxial layer 220, the active layer 230 and the capping layer 240 form the tube core of the LED. Wherein, the epitaxial layer 220 is made of N-doped gallium nitride (n-GaN); the active layer 230 includes a multiple-quantum-well active layer, wherein the multiple-quantum-well active layer is made of indium-gallium nitride (InGaN) to emit blue light with wave length of 470nm; the capping layer 240 is made of P-doped gallium nitride (p-GaN). Since the epitaxial layer 220 and the capping layer 240 are oppositely doped, the N-doped gallium nitride is driven by an external voltage to make electrons drift, while the P-doped gallium nitride is driven by the external voltage to make holes drift, the holes and the electrons are mutually combined in the multiple-quantum-well active layer (also known as active layer) so as to emit light.

The LED further comprises a transparent conductive layer (TCL) 250, wherein the transparent conductive layer 250 is on the capping layer 240. Since the P-doped gallium nitride has a low electric conductivity, a current spreading metal layer is deposited on the surface of the capping layer 240 to raise the electric conductivity. The transparent conductive layer 250 can be made of such materials as Ni/Au.

In addition, since the sapphire substrate 200 does not conduct electricity, in order to connect the tube core of the LED to the positive and negative terminals of the power, the LED further comprises a first electrode 260, a second electrode 270, and an opening 221 with its depth extending to the epitaxial layer 220 (namely an opening 221 passing through the transparent conductive layer 250, the capping layer 240, the active layer 230 and a part of the epitaxial layer 220); wherein the first electrode 260 is on the transparent conductive layer 250 to connect the transparent conductive layer 250 to the positive terminal of the power; the second electrode 270 is in the opening 221 to connect the epitaxial layer 220 to the negative terminal of the power. When the LED is used for light emitting, the first electrode 260 is connected to the positive terminal of the power, the second electrode 270 is connected to the negative terminal of the power, the tube core of the LED is connected to the positive terminal of the power via the first electrode 260, and is connected to the negative terminal of the power via the second electrode 270. The active layer 230 in the tube core of the LED emits light under force of current. The plurality of the bifocal microlens structures 201 increase the light reflected and raise the external quantum efficiency of the LED.

Correspondingly, the present invention further provides a fabrication method of LED, as shown in FIG. 3, which is a flow chart of a fabrication method of LED according to one embodiment of the present invention. The fabrication method of LED comprises the following steps:

> S30, provide a sapphire substrate;
> S31, etch the sapphire substrate to form a plurality of bifocal microlens structures;
> S32, form an epitaxial layer, an active layer and a capping layer on the sapphire substrate in sequence.

The fabrication method of LED of the present invention will be further detailed in combination with the sectional views, which show a preferred embodiment of the present invention. It shall be understood that those skilled in the art may make changes while still realize the favorable effects of the invention based on this description. Therefore, the description below shall be understood as widely known by those skilled in the art rather than the limitation to the present invention.

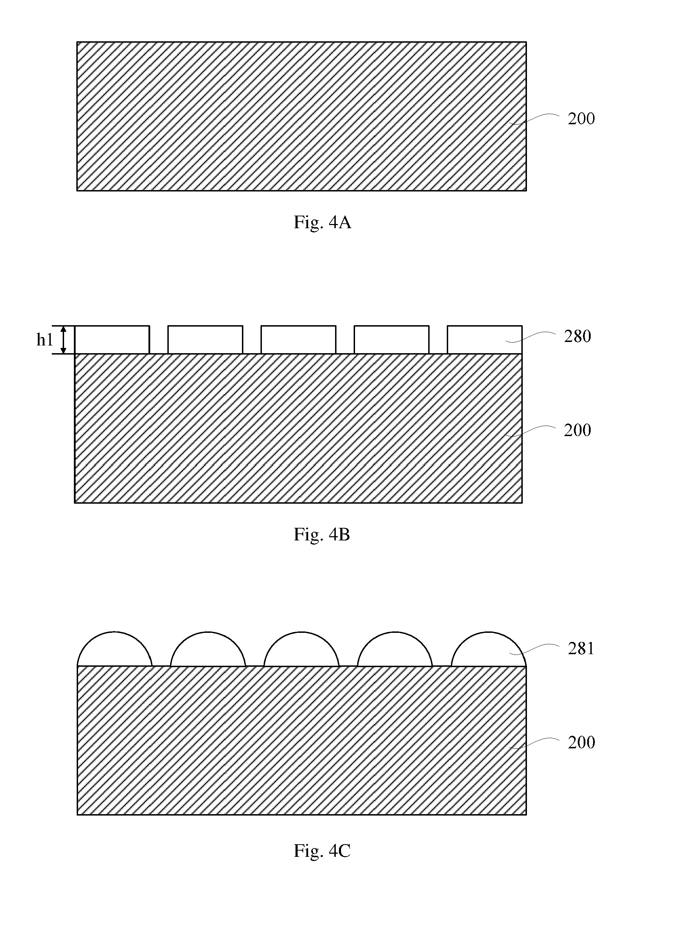

Refer to FIG. 4A, firstly provide a sapphire substrate 200, wherein the sapphire substrate 200 is made of $Al_2O_3$. According to this embodiment, the sapphire substrate 200 is used to form a gallium nitride based blue LED.

Refer to FIG. 4B, then, form a plurality of cylindrical photoresist blocks 280 on the sapphire substrate 200 by photoresist coating, exposing and developing processes.

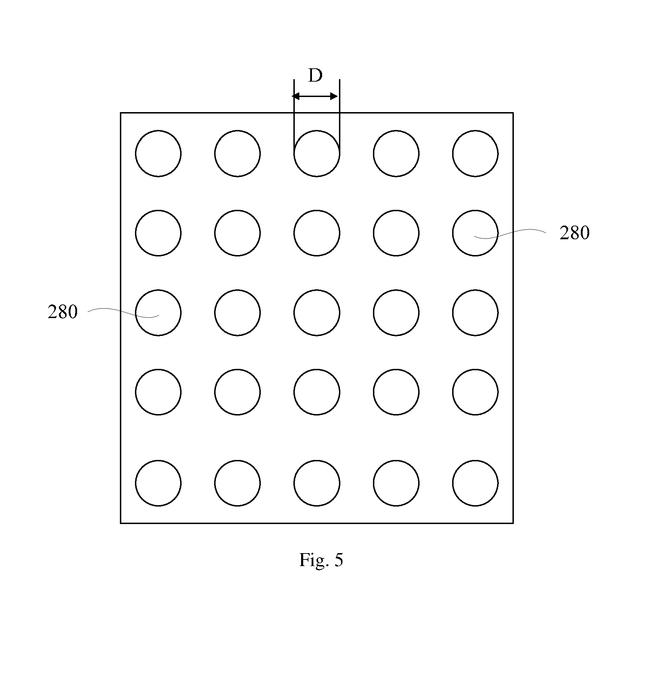

Also refer to FIG. 5, a cylindrical photoresist block 280 refers to a photoresist block whose top view (view along the direction perpendicular to the surface of the sapphire substrate 200) is round-shaped. In this figure, the plurality of cylindrical photoresist blocks 280 are evenly distributed in a two dimensional array. They may also be distributed in other forms according to the design requirements Alternatively, the cylindrical photoresist blocks 280 have a thickness h1 of $0.1\mu m{\sim}5\mu m$ and a diameter D of $1\mu m{\sim}10\mu m$, and the spacing is $0.1\mu m$-$1\mu m$. It shall be understood that those skilled in the art may adjust the dimensions of the cylindrical photoresist blocks 280 according to the desired size of the bifocal microlens structures.

Refer to FIG. 4C, afterwards, bake the cylindrical photoresist blocks 280 to turn the cylindrical photoresist blocks 280 into spherical-crown photoresists 281. In this embodiment, the cylindrical photoresist blocks 280 are baked under the temperature of $120°C{\sim}250°C$. The cylindrical photoresist blocks 280 become spherical-crown photoresists 281 under force of surface tension at a temperature higher than the glass melting temperature of the photoresist.

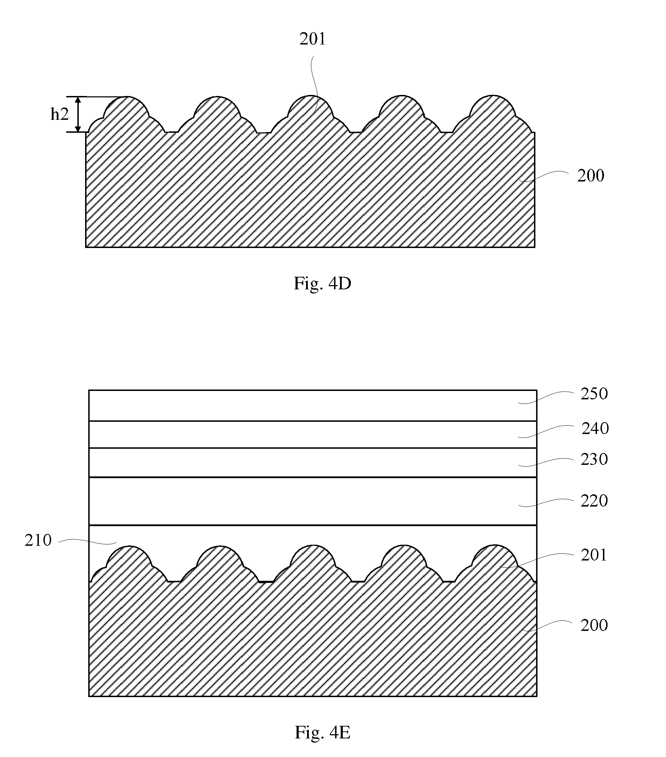

Refer to FIG. 4D, next, perform two steps of inductive coupled plasma (ICP) etch process by using the spherical-crown photoresists 281 as mask until the spherical-crown photoresists 281 are completely etched so as to form a plurality of bifocal microlens structures 201 on the surface of the sapphire substrate 200 close to the epitaxial layer.

In this embodiment, firstly, perform a first inductive coupled plasma etch process; then perform a second inductive coupled plasma etch process, wherein the coil power of the second inductive coupled plasma etch process is lower than the coil power of the first inductive coupled plasma etch process, so as to form bifocal microlens structures with a smaller diameter at the top and a larger diameter at the bottom. The height h2 of the bifocal microlens structures 201 can be $3\mu m{\sim}5\mu m$.

Alternatively, in the first inductive coupled plasma etch process, the etching gas can be a mixture of boron trichloride ($BCl_3$), helium gas (He) and argon gas (Ar), wherein the flow rate of boron trichloride can be, for example, $20{\sim}1000$sccm; the flow rate of helium gas can be, for example, $20{\sim}500$sccm; the flow rate of argon gas can be, for example, $20{\sim}500$sccm; the cavity pressure is 50mTorr~2Torr, the plate power is 200W~300W and the coil power is 300W~500W. In the second inductive coupled plasma etch process, the etching gas is the same as in the first inductive coupled plasma etch process, the cavity pressure is kept unchanged, and the plate power is also kept unchanged, only the coil power is changed, so that the coil power of the second inductive coupled plasma etch process is lower than the coil power of the first inductive coupled plasma etch process, for example 270W~450W

It shall be noted that the description above does not constitute limitation to the present invention. Those skilled in the art may regulate the etching gas and various technical parameters as well as the etching selection ratio according to the real-life conditions of the etching machine so as to form bifocal microlens structures on the sapphire substrate.

Refer to FIG. 4E, in order to further solve the problem of lattice constant mismatch between the sapphire substrate 200 and gallium nitride material, then, form a buffer layer 210 on the sapphire substrate 200 having a plurality of bifocal microlens structures, wherein the buffer layer 210 completely covers the plurality of bifocal microlens structures 201.

After the formation of the buffer layer 210, form an epitaxial layer 220, an active layer 230 and a capping layer 240 on the buffer layer 210 in sequence. The epitaxial layer 220, the active layer 230 and the capping layer 240 constitute the tube core of the LED. The epitaxial layer 220 is made of N-doped gallium nitride; the active layer 230 includes a multiple-quantum-well active layer, wherein the multiple -quantum-well active layer is made of indium-gallium nitride; the capping layer 240 is made of P-doped gallium nitride.

After the formation of the capping layer 240, form a transparent conductive layer 250 on the capping layer 240. The transparent conductive layer 250 is used to raise the electric conductivity. The transparent conductive layer 250 can be made of Ni/Au. The buffer layer 210, the epitaxial layer 220, the active layer 230, the capping layer 240 and the transparent conductive layer 250 can be formed by means of conventional metal organic chemical vapor deposition (MOCVD) processes.

Refer to FIG. 2 again, afterwards, form a first electrode 260 on the transparent conductive layer 250 to connect the transparent conductive layer 250 to the positive terminal of the power; and then form an opening 221 with its depth extending to the epitaxial layer 220 by means of photolithography and etch, after that, form a second electrode 270 in the opening 221 to connect the epitaxial layer 220 to the negative terminal of the power, so as to form the LED as shown in FIG. 2.

It shall be noted that, the blue LED in the above-mentioned embodiment is taken as an example, but this does not constitute limitation to the present invention, the above embodiment can also be applied to red LED, yellow LED. Those skilled in the art may make modification, replacement and deformation to the present invention according to the embodiment above.

To sum up, the present invention provides an LED and its fabrication method, wherein the sapphire substrate of the LED has a plurality of bifocal microlens structures on the surface close to the epitaxial layer. On the one hand, the bifocal microlens structures can increase the light reflected, raising the external quantum efficiency of the LED, thus increasing the light utilization rate of the LED. On the other hand, the bifocal microlens structures can improve the lattice matching between the sapphire substrate and other films, reducing the crystal defects in the film formed on the sapphire substrate, increasing the internal quantum efficiency of the LED, and making sure that the device is unlikely to break. In addition, compared with the prior art, the fabrication method of LED of the present invention has simpler manufacturing process and lower manufacturing cost.

It is clear that those skilled in the art may make various changes and deformations without deviating from the spirit and protection scope of the present invention. If such changes and deformations are within the scope of the claims and the equivalent technological scope, the present invention is also intended to include these changes and deformations.

**Claims**

1. A light emitting diode, comprising:

   a sapphire substrate;
   an epitaxial layer, an active layer and a capping layer arranged on the sapphire substrate in sequence;
   wherein, a plurality of bifocal microlens structures are formed on a surface of the sapphire substrate close to the epitaxial layer.

2. The light emitting diode as claimed in claim 1, **characterized in that**, the light emitting diode further comprises a buffer layer between the sapphire substrate and the epitaxial layer.

3. The light emitting diode as claimed in claim 1, **characterized in that**, the light emitting diode further comprises a transparent conductive layer on the capping layer.

4. The light emitting diode as claimed in claim 3, **characterized in that**, the light emitting diode further comprises a first electrode, a second electrode, and an opening with its depth extending to the epitaxial layer, wherein,
   the first electrode is on the transparent conductive layer to connect the transparent conductive layer to a positive terminal of a power;
   the second electrode is in the opening to connect the epitaxial layer to a negative terminal of the power.

5. The light emitting diode as claimed in claim 1, **characterized in that**, the material of the epitaxial layer is N-doped gallium nitride; the active layer comprises a multiple-quantum-well active layer, the material of the multiple-quantum-well active layer being indium-gallium nitride; the material of the capping layer is P-doped gallium nitride.

6. A fabrication method of the light emitting diode as claimed in claim 1, **characterized in that**, comprising:

   providing a sapphire substrate;
   etching the sapphire substrate to form a plurality of bifocal microlens structures;
   forming an epitaxial layer, an active layer and a capping layer on the sapphire substrate in sequence.

7. The fabrication method as claimed in claim 6, **characterized in that**, the step of forming a plurality of bifocal microlens structures comprises:

   forming a plurality of cylindrical photoresist blocks on the sapphire substrate;
   baking the cylindrical photoresist blocks to turn the cylindrical photoresist blocks into spherical-crown photoresists;
   performing a first inductive coupled plasma etch process by using the spherical-crown photoresists as mask;
   performing a second inductive coupled plasma etch process, wherein, a coil power of the second inductive coupled plasma etch process is lower than a coil power of the first inductive coupled plasma etch process.

8. The fabrication method as claimed in claim 7, **characterized in that**, in the first inductive coupled plasma etch process, the etching gas is a mixture of boron trichloride, helium gas and argon gas, the cavity pressure being 50mTorr~2Torr, the plate power being 200W~300W, the coil power being 300W~500W.

9. The fabrication method as claimed in claim 8, **characterized in that**, in the second inductive coupled plasma etch process, the etching gas is a mixture of boron trichloride, helium gas and argon gas, the cavity pressure being 50mTorr~2Torr, the plate power being 200W~300W, the coil power being 270W~450W.

10. The fabrication method as claimed in claim 6 or 9, **characterized in that**, the cylindrical photoresist blocks are baked under a temperature of 120°C~250°C to turn the cylindrical photoresist blocks into spherical-crown photoresists.

11. The fabrication method as claimed in claim 6 or 9, **characterized in that**, the material of the epitaxial layer is N-doped gallium nitride; the active layer comprises a multiple-quantum-well active layer, the material of the multiple-quantum-well active layer being indium-gallium nitride; the material of the capping layer is P-doped gallium nitride.

**12.** The fabrication method as claimed in claim 6 or 9, further comprising forming a buffer layer on the sapphire substrate before forming the epitaxial layer.

**13.** The fabrication method as claimed in claim 6 or 9, further comprising forming a transparent conductive layer on the capping layer after forming the capping layer.

**14.** The fabrication method as claimed in claim 6 or 9, **characterized in that**, after the formation of the transparent conductive layer, further comprising:

forming a first electrode on the transparent conductive layer;
forming an opening with its depth extending to the epitaxial layer;
forming a second electrode in the opening.

Fig. 1

250

240

230

220

210

260

221

270

201

200

Fig. 2

| provide a sapphire substrate | S30 |

| etch the sapphire substrate to form a plurality of bifocal microlens structures | S31 |

| form an epitaxial layer, an active layer and a capping layer on the sapphire substrate in sequence | S32 |

Fig. 3

Fig. 4A

h1

280

200

Fig. 4B

281

200

Fig. 4C

201

h2

200

Fig. 4D

250

240

230

220

210

201

200

Fig. 4E

Fig. 5

# INTERNATIONAL SEARCH REPORT

| International application No. |
|---|
| **PCT/CN2011/078058** |

## A. CLASSIFICATION OF SUBJECT MATTER

H01L 33/00 (2010.01) i

According to International Patent Classification (IPC) or to both national classification and IPC

## B. FIELDS SEARCHED

Minimum documentation searched (classification system followed by classification symbols)

IPC: H01L 33/-

Documentation searched other than minimum documentation to the extent that such documents are included in the fields searched

Electronic data base consulted during the international search (name of data base and, where practicable, search terms used)

WPI, EPODOC, CNKI, CNPAT, SIPOABS: substrate, sapphire, etch+, lens, microlens, dual lw focus

## C. DOCUMENTS CONSIDERED TO BE RELEVANT

| Category* | Citation of document, with indication, where appropriate, of the relevant passages | Relevant to claim No. |
|---|---|---|
| P, X | CN 102024898 A (XI'AN SHENGUANG ANRUI PHOTOELECTRIC TECHNOLOGY CO., LTD.), 20 April 2011 (20.04.2011), claims 1-14 | 1-14 |
| P, X | CN 102130245 A (ENRAYTEK OPTOELECTRONICS CO., LTD.), 20 July 2011 (20.07.2011), description, paragraphs [0026]-[0055], and figures 2-5 | 1-14 |
| X | KR 10-2008-0026883 A (LG INNOTEK CO., LTD.), 26 March 2008 (26.03.2008), page 3, line 25 to page 4, line 27, and figures 2-3 | 1-6, 11-14 |
| A | US 2008/0290064 A1 (YUN), 27 November 2008 (27.11.2008), the whole document | 1-14 |
| A | CN 1721926 A (SEIKO EPSON CORPORATION), 18 January 2006 (18.01.2006), the whole document | 1-14 |
| A | JP 11-142610 A (SEIKO EPSON CORPORATION), 28 May 1999 (28.05.1999), the whole document | 1-14 |
| A | CN 101867001 A (EPILIGH TECHNOLOGY CO., LTD.), 20 October 2010 (20.10.2010), the whole document | 1-14 |
| A | CN 101336381 A (GWANGJU INSTITUTE OF SCIENCE AND TECHNOLOGY et al.), 31 December 2008 (31.12.2008), the whole document | 1-14 |

☐ Further documents are listed in the continuation of Box C.   ☒ See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 20 September 2011 (20.09.2011) | **20 October 2011 (20.10.2011)** |

| Name and mailing address of the ISA/CN: State Intellectual Property Office of the P. R. China No. 6, Xitucheng Road, Jimenqiao Haidian District, Beijing 100088, China Facsimile No.: (86-10) 62019451 | Authorized officer **ZHOU, Jiang** Telephone No.: (86-10) **62411586** |
|---|---|

Form PCT/ISA/210 (second sheet) (July 2009)

## INTERNATIONAL SEARCH REPORT
### Information on patent family members

| International application No. |
| --- |
| **PCT/CN2011/078058** |

| Patent Documents referred in the Report | Publication Date | Patent Family | Publication Date |
| --- | --- | --- | --- |
| CN 102024898 A | 20.04.2011 | None | |
| CN 102130245 A | 20.07.2011 | None | |
| KR 10-2008-0026883 A | 26.03.2008 | None | |
| US 2008/0290064 A1 | 27.11.2008 | KR 10-2008-0103755 A | 28.11.2008 |
| CN 1721926 A | 18.01.2006 | CN 100520504 C | 29.07.2009 |
| | | US 7394106 B2 | 01.07.2008 |
| | | US 2005274969 A1 | 15.12.2005 |
| | | JP 2006259657 A | 28.09.2006 |
| | | KR 10-2006-0048320 A | 18.05.2006 |
| | | KR 100696159 B1 | 20.03.2007 |
| JP 11-142610 A | 28.05.1999 | None | |
| CN 101867001 A | 20.10.2010 | None | |
| CN 101336381 A | 31.12.2008 | CN 101336381 B | 19.05.2010 |
| | | US 2009068775 A1 | 12.03.2009 |
| | | WO 2007061271 A1 | 31.05.2007 |
| | | KR 10-2007-0055764 A | 31.05.2007 |

Form PCT/ISA/210 (patent family annex) (July 2009)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 1858918 A